(19)

**Europäisches Patentamt**
**European Patent Office**
**Office européen des brevets**

(11) **EP 4 675 945 A1**

(12) **EUROPEAN PATENT APPLICATION**

(43) Date of publication:
   **07.01.2026 Bulletin 2026/02**

(51) International Patent Classification (IPC):
   **H04B 17/318** (2015.01)   **H03G 3/20** (2006.01)

(21) Application number: **25164505.7**

(52) Cooperative Patent Classification (CPC):
   **H04B 17/318; H03G 3/3052; H03G 3/3078**

(22) Date of filing: **18.03.2025**

(84) Designated Contracting States:
   **AL AT BE BG CH CY CZ DE DK EE ES FI FR GB GR HR HU IE IS IT LI LT LU LV MC ME MK MT NL NO PL PT RO RS SE SI SK SM TR**
   Designated Extension States:
   **BA**
   Designated Validation States:
   **GE KH MA MD TN**

(30) Priority: **03.07.2024 KR 20240087805**

(71) Applicant: **Samsung Electronics Co., Ltd.**
   **Suwon-si, Gyeonggi-do 16677 (KR)**

(72) Inventor: **YANG, Hyekyeong**
   **16677 Suwon-si (KR)**

(74) Representative: **Marks & Clerk LLP**
   **15 Fetter Lane**
   **London EC4A 1BW (GB)**

(54) **WIRELESS COMMUNICATION DEVICE FOR CONTROLLING RECEIVED POWER OF HETEROGENEOUS SIGNALS AND OPERATING METHOD THEREOF**

(57)   An operating method of a wireless communication device includes detecting a first root mean square (RMS) value for a received power of a first signal in an $n^{th}$ slot, n being a positive integer, and the first signal being a synchronization signal block (SSB), a channel state information-reference signal (CSI-RS) or a tracking reference signal (TRS), detecting a second RMS value for a received power of a second signal in the $n^{th}$ slot, the second signal being a physical downlink shared channel (PDSCH) demodulation reference signal (DMRS), determining a target RMS value for an $(n+1)^{th}$ slot based on at least one of the first RMS value or the second RMS value, and controlling a gain for the first signal and a gain for the second signal based on the target RMS value for the $(n+1)^{th}$ slot.

FIG. 4

**Description**

BACKGROUND

The inventive concepts relate to a wireless communication device and an operating method thereof. Specifically, the inventive concepts relate to a wireless communication device for controlling received power and an operating method thereof.

In many communication systems, including 5th generation (5G) and 6th generation (6G) systems, wireless communication devices, such as base stations or terminals, may receive signals and detect transmitted data by demodulating and decoding the received signals. To this end, wireless communication devices include a circuit for processing received signals. In general, technology is used which maintains the magnitude of a signal used for demodulation and decoding at a certain level by appropriately controlling a gain of a signal during processing of radio signals. This technology may be referred to as automatic gain control (AGC).

Wireless communication devices may receive various types of signals.

SUMMARY

The inventive concepts provide a wireless communication device for controlling received power of heterogeneous signals and an operating method thereof. Embodiments may enable a method of controlling a gain of received power by taking into account the types of signals received by wireless communication devices.

According to an aspect of the inventive concepts, there is provided an operating method of a wireless communication device, the operating method including detecting a first root mean square (RMS) value for a received power of a first signal in an $n^{th}$ slot, n being a positive integer, and the first signal being a synchronization signal block (SSB), a channel state information-reference signal (CSI-RS) or a tracking reference signal (TRS), detecting a second RMS value for a received power of a second signal in the $n^{th}$ slot, the second signal being a physical downlink shared channel (PDSCH) demodulation reference signal (DMRS), determining a target RMS value for an $(n+1)^{th}$ slot based on at least one of the first RMS value or the second RMS value, and controlling a gain for the first signal and a gain for the second signal based on the target RMS value for the $(n+1)^{th}$ slot.

According to an aspect of the inventive concepts, there is provided a wireless communication device including processing circuitry configured to detect a first root mean square (RMS) value for a received power of a first signal in an $n^{th}$ slot, n being a positive integer, and the first signal being a synchronization signal block (SSB), a channel state information-reference signal (CSI-RS) or a tracking reference signal (TRS), detect a second RMS value for a received power of a second signal in the $n^{th}$ slot, the second signal being a physical downlink shared channel (PDSCH) demodulation reference signal (DMRS), determine a target RMS value for an $(n+1)^{th}$ slot based on at least one of the first RMS value or the second RMS value, amplify a gain for the first signal and a gain for the second signal based on the target RMS value for the $(n+1)^{th}$ slot.

According to an aspect of the inventive concepts, there is provided an operating method of a wireless communication device, the operating method including receiving cell common signals and a physical downlink shared channel (PDSCH) demodulation reference signal (DMRS) in a first slot, the cell common signals including at least one of a synchronization signal block (SSB), a channel state information-reference signal (CSI-RS) or a tracking reference signal (TRS), detecting root mean square (RMS) values for received power of each of the cell common signals and the PDSCH DMRS in the first slot to obtain detected RMS values, and setting a target RMS value associated with a second slot based on the detected RMS values, the second slot being subsequent to the first slot.

The following features may apply to any of the above described aspects.

The determining the target RMS value for the $(n+1)^{th}$ slot may performed by applying one of a number of different relationships based on at least one of the first RMS value or the second RMS value. The applying one of the number of different relationships may comprise determining the target RMS value based on a larger one of the first RMS value or the second RMS value. The applying one of the number of different relationships may comprise updating a target RMS value based on a difference between the first RMS value and the second RMS value.

The gain for the first signal and the gain for the second signal may be a same value. The first signal and the second signal may be referred to collectively as received signals.

The gain for the first signal and the gain for the second signal may be different values. The method may comprise controlling the gain for the first signal based on a first sub-target value and controlling the gain for the second signal based on the second sub-target value.

The operating method may comprise determining a first accumulated RMS value for the received power of the first signal, the first accumulated RMS value being accumulated up to an $(n-1)^{th}$ slot; determining a second accumulated RMS value for the received power of the first signal, the second accumulated RMS value being accumulated up to the $n^{th}$ slot based on the first RMS value and the first accumulated RMS value; determining a third accumulated RMS value for the received power of the second signal, the third accumulated RMS value being accumulated up to the (n-1)$^{th}$ slot; and determining a fourth accumulated RMS value for the received power of the second signal, the fourth accumulated RMS value being accumulated up to the n$^{th}$ slot based on the second RMS value and the third accumulated RMS value. The operating method may comprise storing each of the first accumulated RMS value, the second accumulated RMS value, the third accumulated RMS value, and the fourth accumulated RMS value, e.g. in a memory of the wireless communication device. Calculating each of the accumulated values may comprise performing a sum of RMS values calculated for different slots. Each sum may be a weighted sum, weighted in accordance with a different parameter.

The operating method is implemented by the wireless communication device.

At least some of the above and other features of the invention are set out in the claims.

BRIEF DESCRIPTION OF THE DRAWINGS

Embodiments will be more clearly understood from the following detailed description taken in conjunction with the accompanying drawings in which:

FIG. 1 illustrates a wireless communication system according to embodiments;
FIG. 2 illustrates a block diagram of a wireless communication device according to embodiments;
FIG. 3 illustrates a wireless communication device according to embodiments;
FIG. 4 illustrates a block diagram of a wireless communication device according to embodiments;
FIG. 5 illustrates a wireless communication device according to embodiments;
FIG. 6A is a flowchart illustrating an operating method of a wireless communication device, according to embodiments;
FIG. 6B is a diagram illustrating received power update of a tracking reference signal (TRS) in terms of slots;
FIG. 6C is a diagram illustrating received power update of a TRS in terms of symbols;
FIG. 7A is a diagram illustrating an operation of a wireless communication device according to embodiments;
FIG. 7B is a diagram illustrating an operation in which a wireless communication device accumulates a root mean square (RMS) value of received power, according to embodiments;
FIG. 8A is a flowchart illustrating an operating method of a wireless communication device, according to embodiments;
FIG. 8B is a diagram illustrating an operation of a wireless communication device when a power level of a received signal is irregularly large, according to embodiments;
FIG. 9A is a flowchart illustrating an operating method of a wireless communication device, according to embodiments;
FIG. 9B illustrates an example of resource allocation for a TRS and a data signal;
FIG. 10 is a flowchart illustrating an operating method of a wireless communication device, according to embodiments;
FIG. 11 is a flowchart illustrating an operating method of a wireless communication device, according to embodiments;
FIG. 12 is a flowchart illustrating an operating method of a wireless communication device, according to embodiments; and
FIG. 13 illustrates a block diagram of an electronic device according to embodiments.

DETAILED DESCRIPTION

Hereinafter, embodiments will be described in detail with reference to the accompanying drawings.

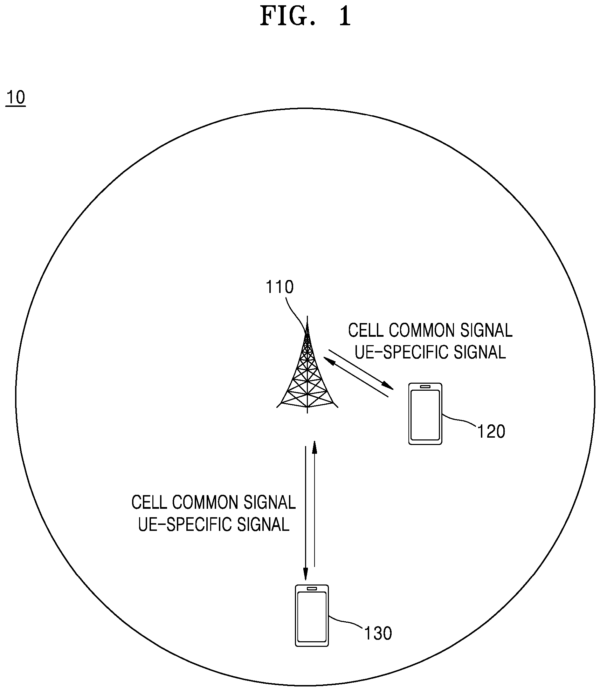

FIG. 1 illustrates a wireless communication system 10 according to embodiments.

Referring to FIG. 1, the wireless communication system 10 may include wireless communication devices 120 and 130, and/or a base station 110. For convenience of explanation, the wireless communication system 10 is illustrated as including only one base station 110 and two wireless communication devices 120 and 130, but this is only an example. The inventive concepts are not limited thereto, and the wireless communication system 10 may be implemented to include various numbers of base stations and wireless communication devices.

The base station 110 may be an entity that communicates with the wireless communication devices 120 and 130, and allocates communication network resources to the wireless communication devices 120 and 130. The base station 110 may be any one of a cell, a BS, a NodeB (NB), an eNodeB (eNB), a next generation radio access network (NG RAN), a radio access unit, a base station controller, a node on a network, a gNodeB (gNB), and/or a transmission and reception point.

Each of the wireless communication devices 120 and 130 is an entity that communicates with the base station 110 or other wireless communication devices. Each of the wireless communication devices 120 and 130 may be referred to as a node, a user equipment (UE), a next generation LTE (NG UE), a mobile station (MS), a mobile equipment (ME), a device, and/or a terminal.

In addition, each of the wireless communication devices 120 and 130 may include at least one of a smartphone, a tablet personal computer (PC), a mobile phone, a video phone, an e-book reader, a desktop PC, a laptop PC, a netbook computer, a personal digital assistant (PDA), a portable multimedia player (PMP), an MP3 player, a medical instrument, a camera, and/or a wearable device. In addition, each of the wireless communication devices 120 and 130 may include at least one of a television, a digital video disk (DVD) player, an audio device, a refrigerator, an air conditioner, a vacuum cleaner, an oven, a microwave oven, a washing machine, an air purifier, a set-top box, a home automation control panel, a security control panel, a media box (e.g., Samsung HomeSync™, AppleTV™, Google TV™, etc.), a game console (e.g., Xbox™, PlayStation™, etc.), an electronic dictionary, an electronic key, a camcorder, and/or an electronic picture frame. Furthermore, each of the wireless communication devices 120 and 130 may include at least one of various medical instruments (e.g., various portable medical measuring devices (blood glucose meters, heart rate monitors, blood pressure monitors, body temperature monitors, etc.), magnetic resonance angiography (MRA), magnetic resonance imaging (MRI), computed tomography (CT), an imaging device, an ultrasound instrument, etc.), a navigation system, a global navigation satellite system (GNSS), an event data recorder (EDR), a flight data recorder (FDR), an automobile infotainment device, an electronic equipment for vessels (e.g., a vessel navigation device, a gyrocompass, etc.), avionics, a security device, a head unit for vehicles, an industrial or domestic robot, a drone, an automated teller machine (ATM) for financial institutions, a point of sales (POS) for stores, and/or an Internet-of-Things device (e.g., light bulbs, various sensors, sprinkler systems, fire alarms, thermostats, street lights, toasters, exercise equipment, hot water tanks, heaters, boilers, etc.). Furthermore, each of the wireless communication devices 120 and 130 may include various types of multimedia systems capable of performing a communication function.

The base station 110 may be connected to the wireless communication devices 120 and 130 over a radio channel and provide various communication services to the wireless communication devices 120 and 130. The base station 110 may provide a service over a shared channel for all user traffics and may collect and schedule state information, such as buffer states, available transmission power states, and channel states of the wireless communication devices 120 and 130. The wireless communication system 10 may support beamforming technology by using orthogonal frequency division multiplexing (OFDM) as radio access technology. In addition, the wireless communication system 10 may support an adaptive modulation and coding (AMC) scheme that determines a modulation scheme and a channel coding rate according to the channel states of the wireless communication devices 120 and 130.

Furthermore, the wireless communication system 10 may transmit and receive signals by using a wide frequency band existing in a frequency band of 6 GHz or higher. For example, the wireless communication system 10 may increase a data transmission rate by using a millimeter wave band, such as a 28 GHz band or a 60 GHz band. Because the millimeter wave band has relatively large signal attenuation per distance, the wireless communication system 10 may support transmission and reception based on directional beams generated by using multiple antennas so as to ensure coverage. The wireless communication system 10 may be a system that supports multiple input multiple output (MIMO), and accordingly, the base station 110 and the wireless communication devices 120 and 130 may support beamforming technology. The beamforming technology may be classified into digital beamforming, analog beamforming, hybrid beamforming, etc.

The base station 110 may transmit a cell common signal and a UE-specific signal to each of the wireless communication devices 120 and 130. In the inventive concepts, the cell common signal may be a signal that the base station 110 commonly transmits to the wireless communication devices 120 and 130 included in the same cell (or similar cells). For example, the cell common signal may include a synchronization signal block (SSB), a channel state information-reference signal (CSI-RS), and/or a tracking reference signal (TRS). Unlike the UE-specific signal, the cell common signal may be used by the wireless communication devices 120 and 130 to simultaneously (or contemporaneously) measure the channel states thereof. The cell common signal may also include various reference signals and is not limited to the examples described above. The UE-specific signal may be a signal that the base station 110 transmits to a specific wireless communication device (e.g., without transmitting the UE-specific signals to other wireless communication devices). For example, the UE-specific signal may include a physical downlink control channel (PDCCH), a physical downlink shared channel (PDSCH), and/or a PDSCH demodulation reference signal (DMRS). The base station 110 may transmit, to the wireless communication device 120, a PDSCH DMRS for the wireless communication device 120 and may transmit, to the wireless communication device 130, a PDSCH DMRS (e.g., a different PDSCH DMRS) for the wireless communication device 130.

The wireless communication devices 120 and 130 may control a gain of a received signal, based on the intensity of the cell common signal. Unlike the UE-specific signal, the cell common signal may be used by the wireless communication devices 120 and 130 to simultaneously (or contemporaneously) measure the channel states thereof, and thus, the cell common signal may be transmitted at higher power than the UE-specific signal by taking into account the cell coverage. When the cell common signal is transmitted at higher power than the UE-specific signal, power mismatch between the cell common signal and the UE-specific signal may occur within one slot (e.g., the same slot or similar slots).

Moreover, as the wireless communication device is (or gets) closer to the base station, the power mismatch may become more severe. For example, because the wireless communication device 120 is closer to the base station 110 than the wireless communication device 130, received power of the cell common signal of the wireless communication device 120 may be higher than that of the wireless communication device 130. In this case, when the wireless communication device 120 controls the gain of the received signal, based on the cell common signal, the power mismatch between the cell common signal and the UE-specific signal may further increase.

The wireless communication devices 120 and 130 according to the inventive concepts may track the power of received signals by distinguishing and storing the power levels of the received signals for each type of the received signals.

The wireless communication devices 120 and 130 according to embodiments may each receive a first signal and a respective second signal. The received signals discussed above may include the first signal and the respective second signal. The wireless communication devices 120 and 130 may detect a first root mean square (RMS) value for received power of the first signal in an $n^{th}$ slot (where n is a positive integer). The wireless communication devices 120 and 130 may detect a second RMS value for received power of the second signal in the $n^{th}$ slot. The wireless communication devices 120 and 130 may determine a target RMS value for an $(n+1)^{th}$ slot, based on at least one of the first RMS value or the second RMS value. The target RMS value may be a reference value for amplifying the first RMS value and the second RMS value. The wireless communication devices 120 and 130 may amplify a gain for the first signal and a gain for the second signal, based on the target RMS value. The first signal may be a cell common signal. The first signal may include any one of an SSB, a CSI-RS, and a TRS. The second signal may include a PDCCH and a PDSCH. The second signal may be a UE-specific signal. Specifically, the second signal may include a PDCCH DMRS.

The wireless communication devices 120 and 130 according to the inventive concepts may set the target RMS value by taking into account both the cell common signal and the UE-specific signal. Specifically, the wireless communication devices 120 and 130 may set the target RMS value by taking into account a signal with higher received power among the cell common signal and the UE-specific signal. The wireless communication devices 120 and 130 may amplify the received power of the cell common signal and the UE-specific signal by using the set target RMS value. Even when the wireless communication devices 120 and 130 amplify a signal with higher received power among the cell common signal and the UE-specific signal by using the target RMS value, an entire range of an output signal of a variable gain amplifier of each of the wireless communication devices 120 and 130 may not exceed a dynamic range of an analog-to-digital converter (ADC). In addition, the wireless communication devices 120 and 130 may increase a signal-to-noise ratio (SNR) by controlling the gain of the received signal, based on sufficiently high power.

In embodiments, the received power of the cell common signal received by the wireless communication device 120 may be higher than the received power of the UE-specific signal received by the wireless communication device 120. Even when the wireless communication device 120 amplifies the cell common signal by using the target RMS value, the wireless communication device 120 may set the target RMS value so that the entire range of the output signal of the variable gain amplifier for the cell common signal does not exceed the dynamic range of the ADC.

In embodiments, the received power of the UE-specific common signal received by the wireless communication device 130 may be higher than the received power of the cell common signal received by the wireless communication device 120. Even when the wireless communication device 120 amplifies the UE-specific signal by using the target RMS value, the wireless communication device 120 may set the target RMS value so that the entire range of the output signal of the variable gain amplifier for the UE-specific signal does not exceed the dynamic range of the ADC. Accordingly, the reception performance of the wireless communication devices 120 and 130 may be improved.

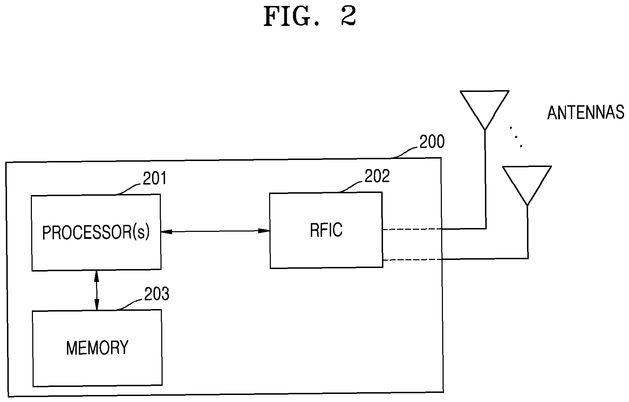

FIG. 2 illustrates a block diagram of a wireless communication device 200 according to embodiments.

Referring to FIG. 2, the wireless communication device 200 may include a processor 201, a radio-frequency integrated circuit (RFIC) 202, and/or a memory 203.

The processor 201 may control overall operations of the wireless communication device 200. For example, the processor 201 may transmit and receive signals through the RFIC 202. In addition, the processor 201 may write data to and read data from the memory 203. The processor 201 may perform functions of a protocol stack required (or otherwise, used) in communication standards. For convenience of explanation, the processor 201, the RFIC 202, and the memory 203 are each represented as one block, but the wireless communication device 200 according to embodiments may include a plurality of processors, a plurality of RFICs, and/or a plurality of memories. The processor 201 may control the wireless communication device 200 to perform operations according to embodiments.

The RFIC 202 may perform functions for transmitting and receiving signals. For example, the RFIC 202 may perform a conversion function between a baseband signal and a bit stream according to a physical layer protocol of a system. For example, upon data transmission, the RFIC 202 may generate complex symbols by encoding and modulating a transmission bit stream. In addition, upon data reception, the RFIC 202 may reconstruct a reception bit stream by demodulating and decoding a baseband signal. Furthermore, the RFIC 202 may up-convert a baseband signal into an RF band signal, transmit the RF band signal through an antenna, and down-convert the RF band signal received through the antenna into the baseband signal. For example, the RFIC 202 may include a transmission filter, a reception filter, an amplifier, a mixer, an oscillator, a digital-to-analog converter (DAC), an ADC, and the like.

The memory 203 may store data such as configuration information, basic programs, and application programs for the operation of the wireless communication device 120. The memory 203 may include a volatile memory, a non-volatile memory, or a combination of a volatile memory and a non-volatile memory. The memory 203 may provide the stored data to the processor 201 in response to a request from the processor 201.

The wireless communication device 200 according to embodiments may receive a first signal and a second signal. The wireless communication device 200 may include the processor 201, the RFIC 202, and/or the memory 203. The RFIC 202 may detect (e.g., under the control of the processor 201) a first RMS value for received power of the first signal in an $n^{th}$ slot (where n is a positive integer). The RFIC 202 may detect (e.g., under the control of the processor 201) a second RMS value for received power of the second signal in the $n^{th}$ slot. The processor 201 may determine a target RMS value for an $(n+1)^{th}$ slot, based on at least one of the first RMS value or the second RMS value. The target RMS value may be a reference value for amplifying the first RMS value and the second RMS value. The processor 201 may control the RFIC 202 to amplify a gain for the first signal and/or a gain for the second signal, based on the target RMS value. The first signal may include any one of an SSB, a CSI-RS, and a TRS. The second signal may include a PDSCH DMRS.

According to embodiments, the processor 201 may store, in the memory 203, a first accumulated RMS value for the received power of the first signal accumulated up to an $(n-1)^{th}$ slot, may store, in the memory 203, a second accumulated RMS value for the received power of the first signal accumulated up to an $n^{th}$ slot, based on the first RMS value and the first accumulated RMS value, may store, in the memory 203, a third accumulated RMS value for the received power of the second signal accumulated up to the $(n-1)^{th}$ slot, and may store, in the memory 203, a fourth accumulated RMS value for the received power of the second signal accumulated up to the $n^{th}$ slot, based on the second RMS value and the third accumulated RMS value.

According to embodiments, the processor 201 may store, in the memory 203, the second accumulated RMS accumulated based on a relationship of second accumulated RMS value = $\alpha$(first RMS value)+(1-$\alpha$)(first accumulated RMS value). $\alpha$ is a real number from 0 to 1. The processor 210 may store, in the memory 203, the fourth accumulated RMS value accumulated based on a relationship of fourth accumulated RMS value = $\beta$(second RMS value)+(1- $\beta$)(third accumulated RMS value). $\beta$ is a real number from 0 to 1.

According to embodiments, $\alpha$ and $\beta$ may decrease when Doppler spread of the channel on which the first signal and the second signal are received increases. The processor 201 may reduce $\alpha$ and $\beta$ when Doppler spread of the channel on which the first signal and the second signal are received increases.

According to embodiments, the processor 201 may reduce $\alpha$ when the difference between the first RMS value and the first accumulated RMS value is greater than a specific value. In addition, the processor 201 may maintain $\alpha$ when the difference between the first RMS value and the first accumulated RMS value is less than or equal to the specific value. The processor 201 may reduce $\beta$ when the difference between the second RMS value and the third accumulated RMS value is greater than the specific value. The processor 201 may maintain $\beta$ when the difference between the second RMS value and the third accumulated RMS value is less than or equal to the specific value.

According to embodiments, the processor 201 may determine a target RMS value for an $(n+1)^{th}$ slot, based on the target RMS value for the $n^{th}$ slot, the second accumulated RMS value, and the fourth accumulated RMS value. The processor 201 may receive configuration information for the first signal from the base station through the RFIC 202. The processor 201 may determine the target RMS value for the $(n+1)^{th}$ slot in symbol units, based on the configuration information.

According to embodiments, the $(n+1)^{th}$ slot may include a first symbol group in which the first signal and the second signal are received simultaneously (or contemporaneously) and a second symbol group in which only the second signal is received. When the second symbol group is greater than or equal to a certain proportion (e.g., relative to the first symbol group), the processor 201 may determine the target RMS value for the $(n+1)^{th}$ slot in symbol units, based on the configuration information. The certain proportion may also be referred to herein as a specific ratio.

According to embodiments, the $(n+1)^{th}$ slot may include a first symbol in which the first signal and the second signal are received simultaneously (or contemporaneously) and a second symbol in which only the second signal is received. The processor 201 may determine a first sub-target RMS value for the first symbol, based on the first RMS value and the second RMS value. The processor 201 may determine a second sub-target RMS value for the second symbol, based on the second RMS value. Together the first sub-target RMS value and the second sub-target RMS value constitute the target RMS value.

The processor 201 according to embodiments may receive cell common signals and a PDSCH DMRS in a first slot through the RFIC 202. The RFIC 202 may detect RMS values for the received power of each of the cell common signals and the PDSCH DMRS in the first slot. The processor 201 may set a target RMS value associated with a second slot subsequent to the first slot, based on the detected RMS values. The cell common signals may include at least one of an SSB, a CSI-RS, or a TRS. The wireless communication device 200 may receive reference signal configuration information from the base station. The target RMS value associated with the second slot may be set further based on the configuration information. According to embodiments, the target RMS value associated with the second slot may be a target RMS value applied to an entire second slot interval. According to embodiments, the target RMS value associated with the second slot may include an RMS value for each of symbols of the second slot. The target RMS value for symbols in which the cell common signals and the PDSCH DMRS are received simultaneously (or contemporaneously) among the symbols of the second slot may be set based on the RMS value for the received power of the cell common signals and the RMS value for the received power of the PDSCH DMRS. The target RMS value for symbols in which the cell common signals are not received among the symbols of the second slot may be set based on the RMS value for the received power of the PDSCH DMRS.

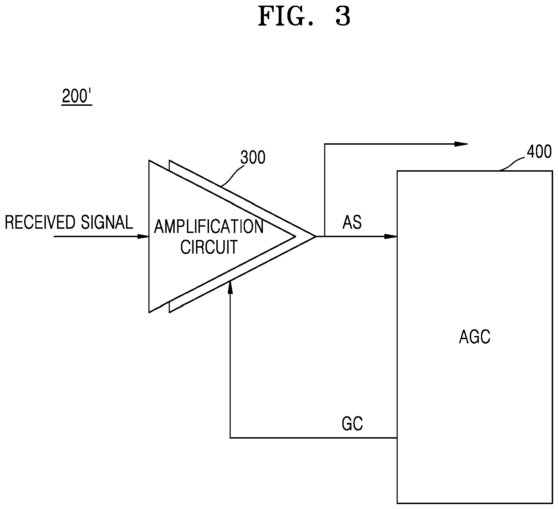

FIG. 3 illustrates a wireless communication device 200' according to embodiments.

FIG. 3 may be described with reference to FIG. 2. The wireless communication device 200' may be understood as a portion of the wireless communication device 200 of FIG. 2. The wireless communication device 200' may include an amplification circuit 300 and/or an automatic gain controller (AGC) 400. The amplification circuit 300 may be a portion of the RFIC 202. According to embodiments, the AGC 400 may be understood as a portion of the RFIC 202 or may be understood as a portion of the RFIC 202 and the processor 201 of FIG. 2.

The amplification circuit 300 may include a low-noise amplifier, a mixer, a variable gain amplifier, and the like. The amplification circuit 300 may amplify the magnitude of a received signal. The amplification circuit 300 may output an amplified signal AS. The AGC 400 may control the gain of the amplification circuit 300. For example, the AGC 400 may receive the amplified signal AS from the amplification circuit 300 and feed a gain control signal GS back to the amplification circuit 300. The amplified signal AS may be transmitted to other circuits for signal processing as well as the AGC 400.

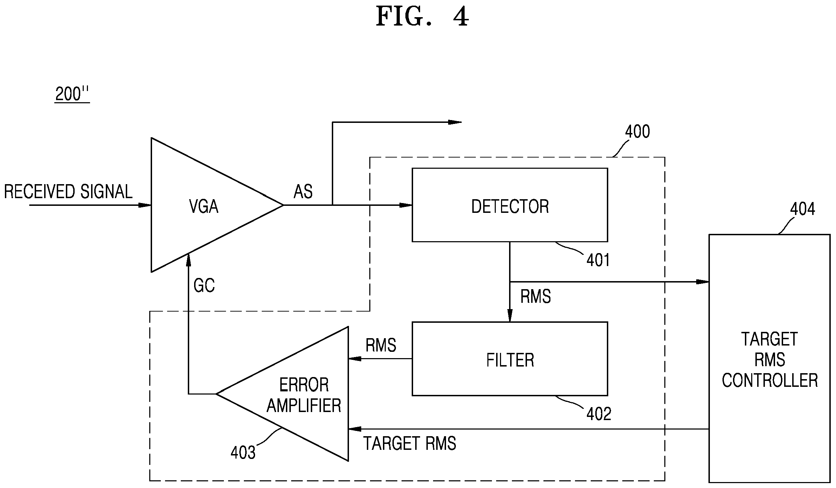

FIG. 4 illustrates a block diagram of a wireless communication device 200" according to embodiments.

FIG. 4 may be described with reference to FIGS. 2 and 3. The wireless communication device 200" may be understood as a portion of the wireless communication device 200 of FIG. 2. Referring to FIG. 4, the wireless communication device 200" may include a variable gain amplifier (VGA), an AGC 400, and/or a target RMS controller 404. The target RMS controller 404 may be understood as a portion of the processor 201 of FIG. 2. According to embodiments, the AGC 400 may include a detector 401, a filter 402, and/or an error amplifier 403. According to embodiments, the target RMS controller 404 may be included in the AGC 400. The target RMS value may be a reference value for amplifying the RMS value for the received power of the received signal.

The VGA may adjust the gain of the received signal. For example, the VGA may amplify the power of the received signal. The received signal input to the VGA may be any one of an RF signal, an intermediate frequency (IF) signal, and/or a baseband signal, depending on a specific implementation. The amplified signal AS may be transmitted to other circuits for subsequent processing (e.g., demodulation or decoding). In addition, the amplified signal AS may be provided to the detector 401.

The detector 401 may detect the magnitude or intensity of the amplified signal AS. For example, the detector 401 may estimate the magnitude of the amplified signal AS. For example, the detector 401 may detect the RMS value of the amplified signal AS. According to embodiments, the detector 401 may detect the amplified signal AS in a format of one of an envelope value and/or a log value.

The magnitude of the amplified signal AS may be filtered (e.g., low-pass-filtered, highpass-filtered, or band-pass-filtered) by the filter 402. According to embodiments, the filter 402 may be omitted. Thereafter, the amplified signal AS may be input to the error amplifier 403.

The error amplifier 403 may compare the RMS value of the amplified signal AS with the target RMS value. The error amplifier 403 may compare the RMS value of the amplified signal AS with the target RMS value, and output a gain control signal GC corresponding to the difference between the RMS value of the amplified signal AS and the target RMS value. The target RMS value may be set by taking into account the dynamic range of the wireless communication device 200.

The gain control signal GC may be input to the VGA. The gain control signal GC may change the amplification level of the VGA. The VGA may determine the amplification level (e.g., gain value) of the received signal, based on the gain control signal GC. The amplification level of the VGA may be determined based on the difference between the RMS value of the amplified received signal and the target RMS value, and the amplification level may be determined so that the magnitude of the amplified signal AS is included in the dynamic range of the error amplifier 403.

A loop formed by the VGA, the detector 401, the filter 402, and the error amplifier 403 may adjust the gain value of the VGA so that the RMS value of the amplified signal AS coincides with or is similar to the target RMS value. The target RMS controller 404 may receive the RMS value of the amplified signal AS from the detector 401. The target RMS controller 404 may adjust the target RMS value based on the received RMS value. The target RMS controller 404 may transmit the adjusted target RMS value to the error amplifier 403. The error amplifier 403 may output the gain control signal GC corresponding to the difference between the RMS value and the target RMS value.

According to embodiments, the target RMS controller 404 may perform an operation in which the wireless communication device 200" updates the target RMS value, which will be described with reference to the accompanying drawings. For example, the target RMS controller 404 may set a target RMS value associated with a subsequent slot, based on the detected RMS value for each of the cell common signals and the PDSCH DMRS.

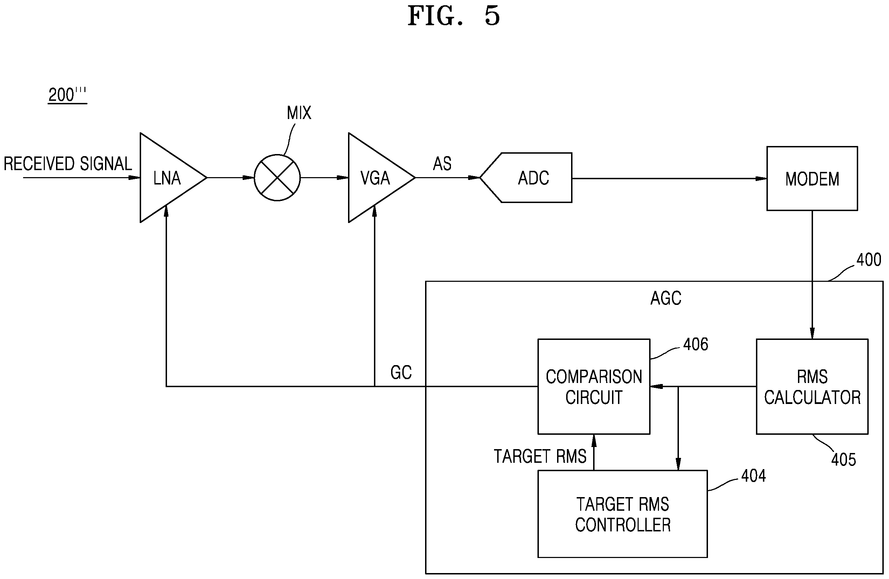

FIG. 5 illustrates a wireless communication device 200''' according to embodiments.

Referring to FIG. 5, the wireless communication device 200''' may include a low-noise amplifier (LNA), a mixer MIX, a VGA, an ADC, a modem, and/or an AGC 400. The wireless communication device 200''' may be understood as a portion of the wireless communication device 200 of FIG. 2. The LNA, the mixer MIX, the VGA, the ADC, and/or the modem may be understood as a portion of the RFIC 202 of FIG. 2. According to embodiments, the AGC 400 may be understood as a portion of the RFIC 202 of FIG. 2 or may be understood as a portion of the RFIC 202 and the processor 201 of FIG. 2. The AGC 400 may include a target RMS controller 404, an RMS calculator 405, and/or a comparison circuit 406. The target RMS value may be a reference value for amplifying the RMS value for the received power of the received signal.

The LNA and the VGA may operate under the control by the AGC 400. The AGC 400 may control the operation of each of the LNA and the VGA by controlling the gain value of each of the LNA and the VGA. The LNA may amplify power of a signal received through an antenna by multiplying the received signal by a preset (or alternatively, given) gain value and may output the amplified signal AS to the mixer MIX. The mixer MIX may down-convert the output signal of the LNA by mixing the output signal of the LNA with a preset (or alternatively, given) frequency signal and may output the down-converted signal to the VGA. The VGA may amplify the down-converted signal output from the mixer MIX by multiplying the down-converted signal by a preset (or alternatively, given) gain value and may output the amplified signal AS to the ADC. The ADC may generate an in-phase and quadrature phase (I/Q) signal by converting the output signal of the VGA, e.g., an analog signal, into a digital signal and may output the I/Q signal to the modem. The modem may demodulate the output signal of the ADC by using a preset (or alternatively, given) demodulation scheme and may output the demodulated signal to the ACG 400. In addition, the output signal of the modem may be input to the AGC 400, and the AGC 400 may determine the gain value for each of the LNA and the VGA included in the wireless communication device 200‴ by using average power of the output signal of the modem. The operation in which the AGC 400 determines the gain value used in the LNA and the gain value used in the VGA is described as follows.

The AGC 400 may detect received power of a signal received for a preset (or alternatively, given) setting time, and then control the gain value of each of the LNA and the VGA, based on the detected received power. For example, the RMS calculator 405 may detect the RMS value of the amplified signal AS. The RMS calculator 405 may transmit the RMS value to the comparison circuit 406 and the target RMS controller 404. The target RMS controller 404 may adjust the target RMS value based on the received RMS value. The target RMS controller 404 may transmit the adjusted target RMS value to the comparison circuit 406. The comparison circuit 406 may output a gain control signal GC, based on the RMS value and the target RMS value. The AGC 400 may operate so that the entire range for the output signal AS of the VGA is mapped to the entire available dynamic range of the ADC. That is, the AGC 400 may generate the gain control signal GC for controlling the gain values of the LNA and the VGA and may transmit the gain control signal GC to the LNA and the VGA, thereby minimizing (or reducing) performance degradation due to quantization noise and saturation.

According to embodiments, the target RMS controller 404 may perform an operation in which the wireless communication device 200‴ updates the target RMS value, which will be described with reference to the accompanying drawings. For example, the target RMS controller 404 may set a target RMS value associated with a subsequent slot, based on the detected RMS value for each of the cell common signals and the PDSCH DMRS.

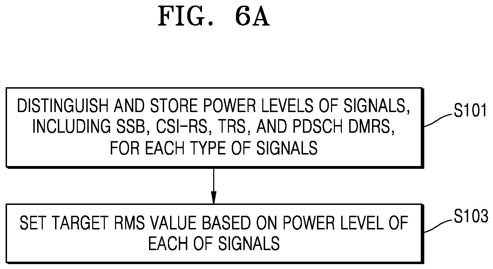

FIG. 6A is a flowchart illustrating an operating method of a wireless communication device, according to embodiments.

FIG. 6A may be described with reference to FIG. 2. Referring to FIG. 6A, in operation S101, the wireless communication device 200 may distinguish and store power levels of signals, including an SSB, a CSI-RS, a TRS, and/or a PDSCH DMRS, for each type of the signals.

According to embodiments, the wireless communication device 200 may receive the CSI-RS, the TRS, and the PDSCH DMRS in the same slot (or similar slots). Hereinafter, for convenience of explanation, it is assumed in the description of FIG. 6A that the wireless communication device 200 receives the CSI-RS, the TRS, and the PDSCH DMRS. The wireless communication device 200 may detect the RMS value for the received power of each of the CSI-RS, the TRS, and/or the PDSCH DMRS. That is, the wireless communication device 200 may detect the received power for the CSI-RS and detect the RMS value for the received power of the CSI-RS. The wireless communication device 200 may detect the received power for the TRS and detect the RMS value for the received power of the TRS. The wireless communication device 200 may detect the received power for the PDSCH DMRS and detect the RMS value for the received power of the PDSCH DMRS. The wireless communication device 200 may store the RMS values for the respective signals in a buffer memory. For example, the wireless communication device 200 may store the RMS value for the received power of the CSI-RS in the buffer memory, may store the RMS value for the received power of the TRS in the buffer memory, and/or may store the RMS value for the received power of the PDSCH DMRS in the buffer memory.

The wireless communication device 200 may detect RMS values for received power of signals for a preset (or alternatively, given) time interval for each of one or more symbols or each of one or more slots. The wireless communication device 200 may store the detected RMS values.

In operation S103, the wireless communication device 200 may set a target RMS value based on the power level of each of the signals. The wireless communication device 200 may set the target RMS value by taking into account the RMS values of the received reference signals rather than set the target RMS value by taking into account only the PDSCH DMRS. The wireless communication device 200 may control the gains of the received signals, based on the target RMS value.

The wireless communication device 200 may set the target RMS value by taking into account all the received signals. For example, the wireless communication device 200 may set the target RMS value by taking into account the RMS value of each of the CSI-RS, the TRS, and the PDSCH DMRS. That is, the wireless communication device 200 may set the target RMS value based on the RMS value for the received power of the CSI-RS, the RMS value for the received power of the TRS, and the RMS value for the received power of the PDSCH DMRS. Specifically, the wireless communication device 200 may set the target RMS value based on a signal with the highest received power among the received signals rather than set the target RMS value based on only the RMS value of the PDSCH DMRS. The wireless communication device 200 may amplify the received power of each of the CSI-RS, the TRS, and the PDSCH DMRS by using the set target RMS value. Even when the wireless communication device 200 amplifies a signal with the highest received power among the CSI-RS, the TRS, and the PDSCH DMRS by using the target RMS value, the amplified gain may not be greater than a threshold value. For example, even when the wireless communication device 200 amplifies a signal with the highest received power among the CSI-RS, the TRS, and the PDSCH DMRS by using the target RMS value, the entire range of the output signal of the VGA of the wireless communication device 200 may not exceed the dynamic range of the ADC. In addition, the wireless communication device 200 may increase an SNR by controlling the gain of the received signal, based on sufficiently high power.

In embodiments, the received power of the CSI-RS received by the wireless communication device 200 may be higher than the received pieces of power of the TRS and the PDSCH DMRS received by the wireless communication device 200. Even when the wireless communication device 200 amplifies the CSI-RS by using the target RMS value, the amplified gain may not be greater than a specific threshold value. Even when the wireless communication device 200 amplifies the CSI-RS by using the target RMS value, the wireless communication device 200 may set the target RMS value so that the entire range of the output signal of the VGA for the CSI-RS does not exceed the dynamic range of the ADC.

Accordingly, clipping of the received pieces of power of the CSI-RS and the TRS may be reduced, compared to a case where the target RMS value is set by taking into account only the received power of the PDSCH DMRS.

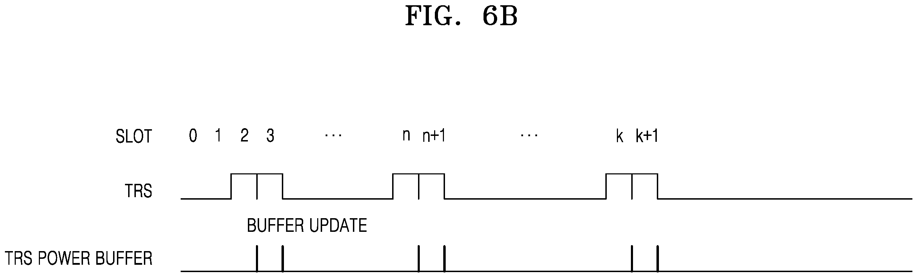

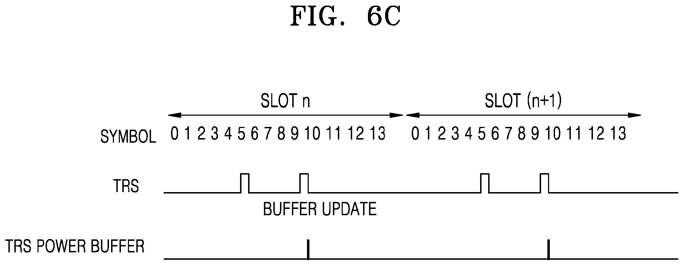

FIG. 6B is a diagram illustrating received power update of a TRS in terms of slots and FIG. 6C is a diagram illustrating received power update of a TRS in terms of symbols.

FIG. 6B may be described with reference to FIGS. 2 and 6A. Although the TRS is described with reference to FIGS. 6B and 6C, the operation of the wireless communication device 200 in FIGS. 6B and 6C may be similarly applied to other signals.

Referring to FIG. 6B, the wireless communication device 200 may include a TRS power buffer as a portion of the memory 203 of FIG. 2. The TRS may be received in two consecutive slots. Referring to FIG. 6B, the wireless communication device 200 may receive the TRS in slot 2, slot 3, slot n, slot n+1, slot k, and slot k+1. The wireless communication device 200 may detect the RMS value for the received power of the TRS in the slot in which the TRS is received. The wireless communication device 200 may store the RMS value in the TRS power buffer.

Referring to FIG. 6C, slot n and slot n+1 each include 14 symbols (symbols 0 to 13). According to embodiments, the number of symbols included in the slot may vary depending on subcarrier spacing (SCS) and is not limited to the example described above. In each slot, the TRS is received on symbol 5 and symbol 9. The wireless communication device 200 may receive the TRS in symbol 5 and symbol 9 of slot n and may detect the RMS value for the received power of the TRS received in slot n. The wireless communication device 200 may store the RMS value in the TRS power buffer. Because the operation in slot n+1 is the same as (or similar to) that described above, a description thereof is omitted.

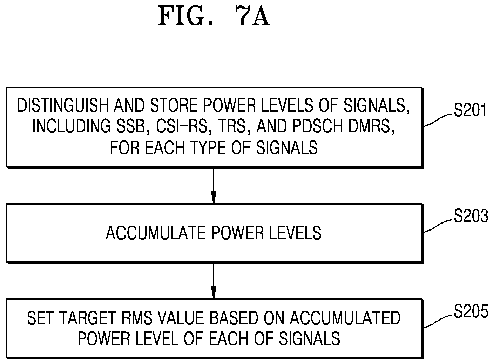

FIG. 7A is a diagram illustrating the operation of a wireless communication device according to embodiments.

FIG. 7A may be described with reference to FIGS. 2 and 6A, and redundant descriptions may be omitted. In operation S201, the wireless communication device 200 may distinguish and store power levels of signals, including an SSB, a CSI-RS, a TRS, and/or a PDSCH DMRS, for each signal. The wireless communication device 200 may receive various signals in the same slot (or similar slots) and is not limited to the examples described above.

According to embodiments, the wireless communication device 200 may receive the CSI-RS, the TRS, and the PDSCH DMRS in the same slot (or similar slots). The wireless communication device 200 may detect the RMS value for the received power of each of the CSI-RS, the TRS, and/or the PDSCH DMRS. The wireless communication device 200 may store the RMS values for the respective signals in a buffer memory. For example, the wireless communication device 200 may store the RMS value for the received power of the CSI-RS in the buffer memory, may store the RMS value for the received power of the TRS in the buffer memory, and may store the RMS value for the received power of the PDSCH DMRS in the buffer memory.

In operation S203, the wireless communication device 200 may accumulate the power levels. The wireless communication device 200 may accumulate RMS values for the received pieces of power of the signals while receiving the signals. The wireless communication device 200 may accumulate the detected RMS values, e.g. to produce the first accumulated RMS value and the third accumulated RMS value. The operation in which the wireless communication device 200 accumulates the RMS value may also be referred to as RMS value update.

According to embodiments, the memory 203 of the wireless communication device 200 may include a CSI-RS power buffer, a TRS power buffer, and/or a PDSCH DMRS power buffer. The wireless communication device 200 may detect the RMS value for the received power of the CSI-RS for each slot in which the CSI-RS is received and may accumulate the RMS value. The accumulated RMS value for the CSI-RS may be stored in the CSI-RS power buffer. The wireless communication device 200 may detect the RMS value for the received power of the TRS for each slot in which the TRS is received and may accumulate the RMS value. The accumulated RMS value for the TRS may be stored in the TRS power buffer. The wireless communication device 200 may detect the RMS value for the received power of the PDSCH DMRS for each slot in which the PDSCH DMRS is received and may accumulate the RMS value. The accumulated RMS value for the PDSCH DMRS may be stored in the PDSCH DMRS power buffer.

In operation S205, the wireless communication device 200 may set a target RMS value based on the accumulated power level of each of the signals.

According to embodiments, the wireless communication device 200 may set the target RMS value by taking into account the accumulated RMS value for the received power of the CSI-RS, the accumulated RMS value for the received power of the TRS, and/or the accumulated RMS value for the received power of the PDSCH DMRS.

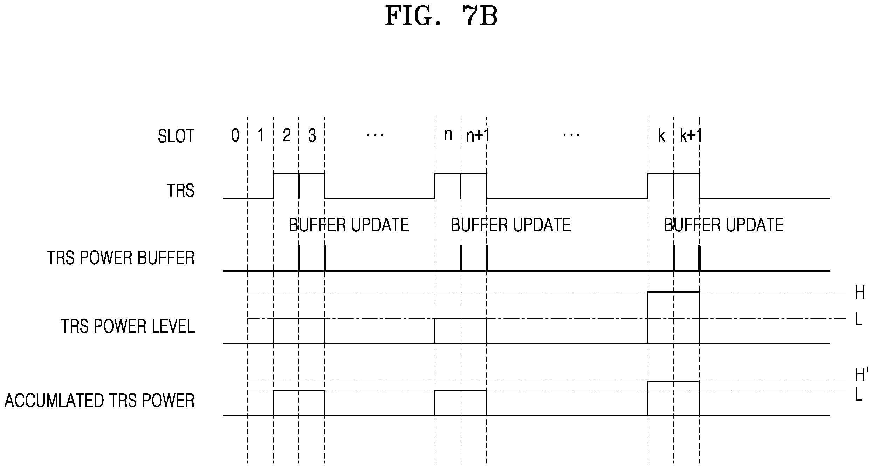

FIG. 7B is a diagram illustrating an operation in which a wireless communication device accumulates an RMS value of received power, according to embodiments.

FIG. 7B may be described with reference to FIGS. 2, 6A, and 7A, and redundant descriptions may be omitted. Referring to FIG. 7B, the wireless communication device 200 may include a TRS power buffer as a portion of the memory 203 of FIG. 2. The wireless communication device 200 may receive the TRS in slot 2, slot 3, slot n, slot n+1, slot k, and slot k+1.

The wireless communication device 200 may detect the RMS value for the received power of the TRS in the slot in which the TRS is received. The wireless communication device 200 may accumulate the detected RMS value whenever the wireless communication device 200 receives the TRS. The wireless communication device 200 may store the accumulated RMS value in the TRS power buffer. Accordingly, the TRS power buffer may be updated.

Referring to FIG. 7B, the TRS power level may refer to the intensity of the average received power of the TRS received in each slot. The accumulated TRS power may refer to the accumulated value of the average received power of the TRS received up to the corresponding slot. Specifically, the wireless communication device 200 may receive the TRS in slot 2, slot 3, slot n, slot n+1, slot k, and slot k+1 and may measure the average power of the TRS in each slot. The wireless communication device 200 may detect the RMS value for the received power of the TRS in each slot. For example, the wireless communication device 200 may detect the RMS value of L [dB] in each of slot 2, slot 3, slot n, and slot n+1. The wireless communication device 200 may detect the RMS value of H [Db] in each of slot k and slot k+1. The wireless communication device 200 may accumulate the RMS value for the received power of the TRS. The wireless communication device 200 may accumulate the RMS value based on (e.g., to have an accumulated RMS value of) the difference between a previously accumulated RMS value and an RMS value for a current slot. For example, the RMS value for the received power of the TRS accumulated in slot k and slot k+1 may be H' [dB], which is less than H [dB] and greater than L [dB].

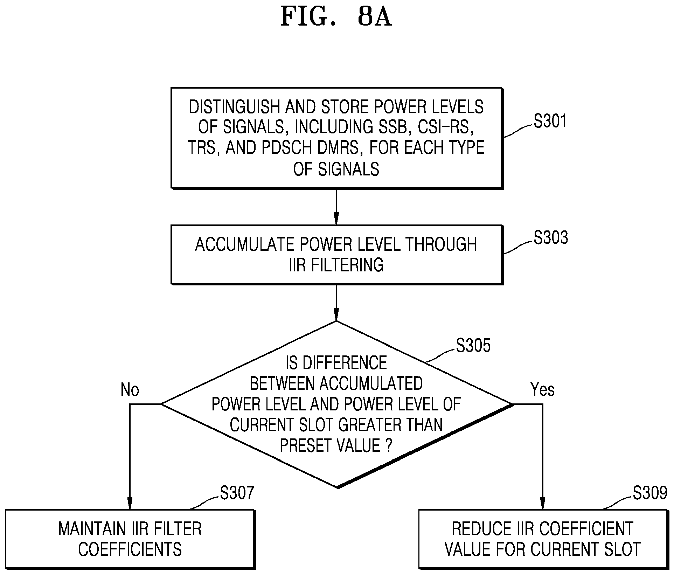

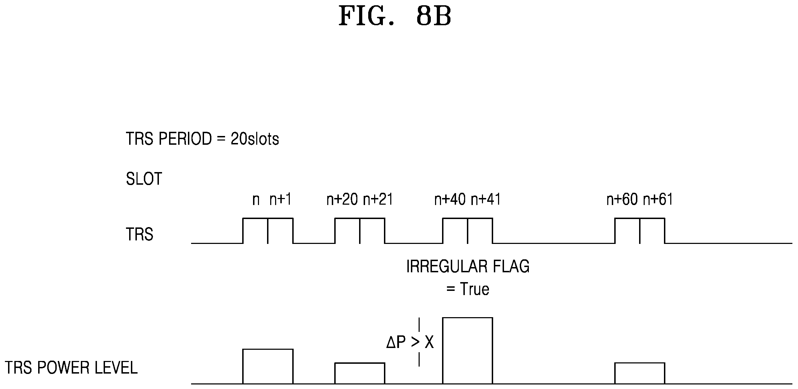

FIG. 8A is a flowchart illustrating the operating method of a wireless communication device, according to embodiments. FIG. 8B is a diagram illustrating the operation of the wireless communication device 200 of FIG. 2 when the power level of the received signal is irregularly large, according to embodiments.

FIGS. 8A and 8B may be described with reference to FIG. 2. Referring to FIG. 8A, in operation S301, the wireless communication device 200 may distinguish and store power levels of signals, including an SSB, a CSI-RS, a TRS, and/or a PDSCH DMRS, for each signal.

In operation S303, the wireless communication device 200 may accumulate the power level through infinite impulse response (IIR) filtering. Specifically, the wireless communication device 200 may accumulate average power in the current slot, based on a ratio of the average power of the current slot and the average power accumulated in the previous slot for each of the received signals. The TRS is described below as an example.

The TRS power accumulated in slot n may be expressed as follows.

[Equation 1]

$$P_{TRSacuum}[n] = \alpha P_{TRSinst}[n] + (1 - \alpha)P_{TRSacuum}[n - 1]$$

$P_{TRSacuum}[n]$ represents the received power of the TRS accumulated in slot n. $P_{TRSinst}[n]$ represents the average of instantaneous powers of the TRS in slot n. $P_{TRSacuum}[n - 1]$ represents the received power of the TRS accumulated in slot n-1. $\alpha$ is a real number from 0 to 1 and is an IIR filter coefficient.

According to embodiments, the IIR filter coefficient may be determined by taking into account Doppler spread. The IIR filter coefficient may be expressed as the following equation.

[Equation 2]

$$IIR\ filter\ coefficient\ \alpha = \begin{cases} n_1, when\ doppler < d_1 \\ n_2, when\ d_1 \leq doppler < d_2, n_1 > n_2 > n_3\ and, d_1 > d_2 \\ n_3, when\ d_2 \leq doppler < d_3 \end{cases}$$

$$> d_3$$

n1, n2, and n3 are each a real number from 0 to 1. The wireless communication device 200 may reduce the IIR filter coefficient when the Doppler spread of the channel increases.

In operation S305, the wireless communication device 200 may determine whether the difference between the accumulated power level and the power level of the current slot is greater than a preset (or alternatively, given) value. Referring to FIG. 8B, the wireless communication device 200 may receive the TRS in slot n+40 and slot n+41. The wireless communication device 200 may compare a difference ΔP, between the RMS value for the received power of the TRS detected in slot n+40 and slot n+41 and the accumulated RMS value for the received power of the TRS in slot n+20 and slot n+21, with a preset (or alternatively, given) value X.

Referring again to FIG. 8A, in operation S307, when the difference between the accumulated power level and the power level of the current slot is not greater than the preset (or alternatively, given) value, the wireless communication device 200 may maintain the IIR filter coefficients. In operation S309, when the difference between the accumulated power level and the power level of the current slot is greater than the preset (or alternatively, given) value, the wireless communication device 200 may reduce the IIR coefficient value for the current slot. Due to this, the wireless communication device 200 may reduce the influence of received power of an abnormal signal. Accordingly, the reception performance of the wireless communication device 200 may be improved.

Referring to FIG. 8B, when the difference ΔP between the RMS value for the received power of the TRS detected in slot n+40 and slot n+41 and the accumulated RMS value for the received power of the TRS in slot n+20 and slot n+21 is greater than a preset (or alternatively, given) value X, the wireless communication device 200 may reduce the IIR coefficient value. That is, the wireless communication device 200 may reduce the ratio of the RMS value for the received power of the TRS detected in slot n+40 and slot n+41 from the RMS value accumulated in slot n+40 and slot n+41.

The operating method of the wireless communication device described above may be applied to other signals, such as an SSB, a CSI-RS, or a PDSCH DMRS, and the inventive concepts are not limited to the example of the TRS described above.

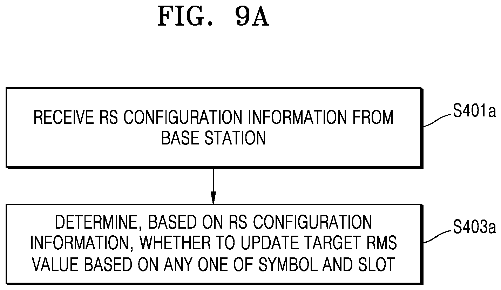

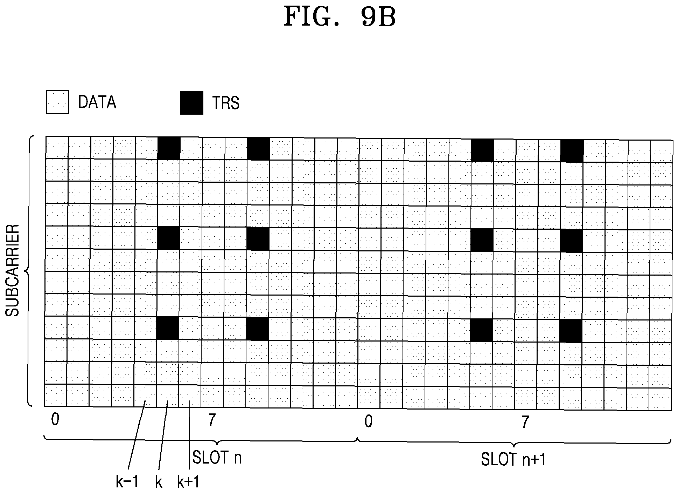

FIG. 9A is a flowchart illustrating an operating method of a wireless communication device, according to embodiments. FIG. 9B illustrates an example of resource allocation for a TRS and a data signal.

FIG. 9A may be described with reference to FIG. 2. Referring to FIG. 9A, in operation S401a, the wireless communication device 200 may receive reference signal (RS) configuration information from the base station. For example, the wireless communication device 200 may receive a radio resource control (RRC) signal, including the RS configuration information, from the base station. The wireless communication device 200 may predict a position of a reference signal to be received in a next slot, based on the RS configuration information. The RS configuration information may include a frequency domain position, a symbol position, and/or a transmission period for the reference signal. In the 3GPP TS 38.331 specification, when NZP-CSI-RS-ResourceSet.trs-info = True, the corresponding CSI-RS configuration information may refer to information about TRS. The wireless communication device 200 may predict resource mapping of TRS, based on the RS configuration information received from the base station, as illustrated in FIG. 9B.

In operation S403a, the wireless communication device 200 may determine, based on the RS configuration information, whether to update the target RMS value based on any one of a symbol and/or a slot.

According to embodiments, when the ratio of symbols (e.g., quantity of symbols) in which only PDSCH DMRS is received in the next slot is greater than or equal to a preset (or alternatively, given) ratio, the wireless communication device 200 may update the target RMS value for each slot during at least one slot period from the next slot, based on the RS configuration information.

According to embodiments, the wireless communication device 200 may update the target RMS value for each slot. The wireless communication device 200 may predict the target RMS value for slot n in slot n-1. Referring to FIG. 9B, slot n-1 is omitted and slot n and slot n+1 are shown. Data signals may include PDSCH and PDSCH DMRS. The wireless communication device 200 may predict the target RMS value for next slot n in slot n-1, as expressed in Equation 3 below.

[Equation 3]

$$RMS_n = RMS_{n-1} + \gamma(\ P_{SCHaccum} - P_{TRSaccum}))\ (dB)$$

In Equation 3, $RMS_n$ is the target RMS value in slot n. $RMS_{n-1}$ is the target RMS value in slot n-1. $P_{SCHaccum}$ is the RMS value for the received power of the PDSCH DMRS accumulated in slot n-1. $P_{TRSaccum}$ is the RMS value for the received power of the TRS accumulated in slot n-1. $\gamma(P_{SCHaccum} - P_{TRSaccum})$ may be a value of which an absolute value is less than or equal to the difference between the RMS value for the received power of the PDSCH DMRS accumulated in slot n-1 and the RMS value for the received power of the TRS accumulated in slot n-1, and may be adjusted as Doppler spread is taken into account.

According to embodiments, the wireless communication device 200 may update the target RMS value for each symbol. Referring to FIG. 9B, the wireless communication device 200 may predict the target RMS value for symbols of slot n in slot n-1. The wireless communication device 200 may predict the target RMS value for the symbols of next slot n in slot n-1, as expressed in Equations 4 and 5 below.

[Equation 4]

$$RMS_k^{symb} = RMS_{k-1}^{symb} + \gamma(P_{SCHaccum} - P_{TRSaccum}))\ (dB)$$

In Equation 4, $RMS_k^{symb}$ refers to the target RMS value in symbol k where the cell common signal exists. $RMS_{k-1}^{symb}$ refers to the target RMS value in symbol k-1, which is a previous symbol of symbol k where the cell common signal exists. $\gamma(P_{SCHaccum} - P_{TRSaccum})$ is a value between the RMS value for the received power of the PDSCH DMRS accumulated in slot n-1 and the RMS value for the received power of the TRS accumulated in slot n-1, and $\gamma$ means that Doppler spread is taken into account. Accordingly, when the cell common signal and the UE-specific signal are received simultaneously (or contemporaneously) in a specific symbol, the wireless communication device 200 may update the target RMS value by taking into account both the cell common signal and the UE-specific signal. $P_{SCHaccum}$ is the RMS value for the received power of the PDSCH DMRS accumulated in slot n-1. $P_{TRSaccum}$ is the RMS value for the received power of the TRS accumulated in slot n-1.

[Equation 5]

$$RMS_{k+1}^{symb} = RMS_{k-1}^{symb} + \delta(P_{SCHinst} - P_{SCHaccum})(dB)$$

In Equation 5, $RMS_{k+1}^{symb}$ refers to the target RMS value in symbol k+1 where the UE-specific signal exists. $RMS_{k-1}^{symb}$ refers to the target RMS value in symbol k-1 where the UE-specific signal exists. Accordingly, the wireless communication device 200 may use the target RMS value of the symbol where only the UE-specific signal exists to update the target RMS value of the symbol where only the UE-specific signal exists, which is received thereafter. $\delta(P_{SCHinst} - P_{SCHaccum})(dB)$ is a value of which an absolute value is less than or equal to the difference between the RMS value for the received power of the PDSCH DMRS detected in symbol k+1 and the RMS value for the received power of the PDSCH DMRS accumulated in slot n-1, and $\delta$ means that Doppler spread is taken into account. $P_{SCHinst}$ is the RMS value for the received power of the PDSCH DMRS detected in symbol k+1. $P_{TRSaccum}$ is the RMS value for the received power of the TRS accumulated in slot n-1.

According to embodiments, the wireless communication device 200 may update the target RMS value for each symbol. When the wireless communication device 200 updates the target RMS value for a subsequent slot in symbol units, the target RMS value for the previous slot in slot units may be used to update the target RMS value for the first symbol of the subsequent slot.

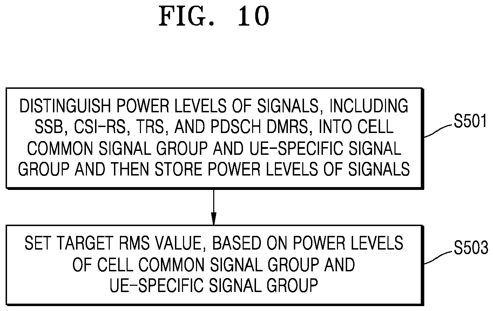

FIG. 10 is a flowchart illustrating an operating method of a wireless communication device, according to embodiments.

FIG. 10 may be described with reference to FIG. 2. Referring to FIG. 10, in operation S501, power levels of signals, including an SSB, a CSI-RS, a TRS, and/or a PDSCH DMRS, may be distinguished into a cell common signal group and a UE-specific signal group and then stored.

In operation S503, the wireless communication device 200 may set the target RMS value, based on the power levels of the cell common signal group and the UE-specific signal group.

According to embodiments, the wireless communication device 200 may set the target RMS value for the next slot, based on the power levels of the cell common signal group and the UE-specific signal group.

According to embodiments, the wireless communication device 200 may set the target RMS value for each of symbols where the cell common signal and the UE-specific signal are received simultaneously (or contemporaneously) among the symbols of the next slot, based on the power levels of the cell common signal group and the UE-specific signal group. In addition, the wireless communication device 200 may set the target RMS value for each of the symbols where only the UE-specific signal is received among the symbols of the next slot, based on the power level of the UE-specific signal group.

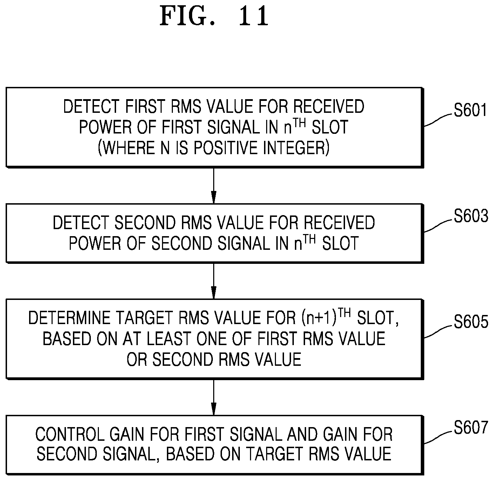

FIG. 11 is a flowchart illustrating an operating method of a wireless communication device, according to embodiments.

FIG. 11 may be described with reference to FIG. 2. In operation S601, the wireless communication device 200 may detect a first RMS value for received power of a first signal in an $n^{th}$ slot (where n is a positive integer). In operation S603, the wireless communication device 200 may detect a second RMS value for received power of a second signal in the $n^{th}$ slot.

According to embodiments, the wireless communication device 200 may store, in the memory 203, a first accumulated RMS value for the received power of the first signal accumulated up to an $(n-1)^{th}$ slot, may store, in the memory 203, a second accumulated RMS value for the received power of the first signal accumulated up to an $n^{th}$ slot, based on the first RMS value and the first accumulated RMS value, may store, in the memory 203, a third accumulated RMS value for the received power of the second signal accumulated up to the $(n-1)^{th}$ slot, and may store, in the memory 203, a fourth accumulated RMS value for the received power of the second signal accumulated up to the $n^{th}$ slot, based on the second RMS value and the third accumulated RMS value.

According to embodiments, the wireless communication device 200 may store, in the memory 203, the second accumulated RMS value accumulated based on a relationship of second accumulated RMS value = $\alpha$(first RMS value)+(1-$\alpha$)(first accumulated RMS value). $\alpha$ is a real number from 0 to 1. The wireless communication device 200 may store, in the memory 203, the fourth accumulated RMS value accumulated based on a relationship of fourth accumulated RMS value = $\beta$(second RMS value)+(1- $\beta$)(third accumulated RMS value). $\beta$ is a real number from 0 to 1.

According to embodiments, $\alpha$ and $\beta$ may decrease when Doppler spread of the channel on which the first signal and the second signal are received increases. The wireless communication device 200 may reduce $\alpha$ and $\beta$ when Doppler spread of the channel on which the first signal and the second signal are received increases.

According to embodiments, the wireless communication device 200 may reduce $\alpha$ when the difference between the first RMS value and the first accumulated RMS value is greater than a specific value. In addition, the wireless communication device 200 may maintain $\alpha$ when the difference between the first RMS value and the first accumulated RMS value is less than or equal to the specific value. The wireless communication device 200 may reduce $\beta$ when the difference between the second RMS value and the third accumulated RMS value is greater than the specific value. The wireless communication device 200 may maintain $\beta$ when the difference between the second RMS value and the third accumulated RMS value is less than or equal to the specific value.

In operation S605, the wireless communication device 200 may determine a target RMS value for an $(n+1)^{th}$ slot, based on at least one of the first RMS value or the second RMS value.

According to embodiments, the wireless communication device 200 may determine the target RMS value based on a larger value between (e.g., among) the first RMS value and the second RMS value. The gain for the first signal and the gain for the second signal may not be greater than a threshold value. For example, the entire range of the output signal of the VGA of the wireless communication device 200 may not exceed the dynamic range of the ADC.

According to embodiments, the wireless communication device 200 may determine a target RMS value for an $(n+1)^{th}$ slot, based on the target RMS value for the $n^{th}$ slot, the second accumulated RMS value, and the fourth accumulated RMS value. The wireless communication device 200 may receive configuration information for the first signal from the base station through the RFIC 202. The wireless communication device 200 may determine the target RMS value for the $(n+1)^{th}$ slot in symbol units, based on the configuration information.

According to embodiments, the $(n+1)^{th}$ slot may include a first symbol group in which the first signal and the second signal are received simultaneously (or contemporaneously), and a second symbol group in which only the second signal is received. When the second symbol group is greater than or equal to a certain proportion (e.g., with respect to a quantity of symbols relative to the first symbol group), the wireless communication device 200 may determine the target RMS value for the $(n+1)^{th}$ slot in symbol units, based on the configuration information.

According to embodiments, the $(n+1)^{th}$ slot may include a first symbol in which the first signal and the second signal are received simultaneously (or contemporaneously), and a second symbol in which only the second signal is received. The wireless communication device 200 may determine a first sub-target RMS value for the first symbol, based on the first RMS value and the second RMS value. The wireless communication device 200 may determine a second sub-target RMS value for the second symbol, based on the second RMS value (e.g., without the first RMS value).

In operation S607, the wireless communication device 200 may control the gain for the first signal and the gain for the second signal, based on the target RMS value. According to embodiments, after adjusting (e.g., changing) a gain for the first signal and/or the second signal (e.g., by adjusting the gain of the amplification circuit 300, the VGA and/or the LNA), the wireless communication device 200 may perform network communication with the base station 110. For example, the wireless communication device 200 may generate a first signal (e.g., using the RFIC 202 and/or the processor 201), process the first signal to perform one or more among modulating, upconverting, filtering, amplifying and/or encrypting on the first signal, and transmit the processed first signal to the base station 110 via the antennas of the wireless communication device 200. Additionally or alternatively, the wireless communication device 200 may receive a second signal from the base station 110 via the antennas of the wireless communication device 200, process the second signal to perform one or more among demodulating, downconverting, filtering, amplifying and/or decrypting on the second signal, and perform a further operation(s) based on the processed second signal. For example, the further operation(s) may include one or more of providing the processed second signal to a corresponding application executing on the wireless communication device 200, storing the processed second signal, sending a response signal to the base station (e.g., based on a processing result of the corresponding application executing on the wireless communication device 200), etc.

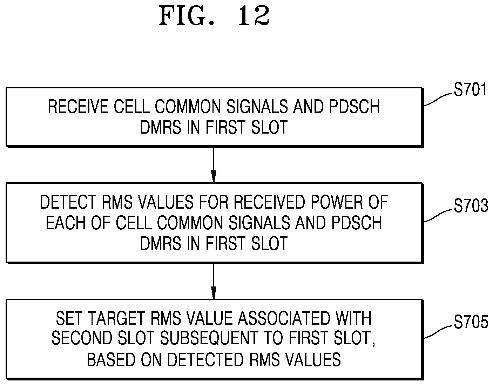

FIG. 12 is a flowchart illustrating an operating method of the wireless communication device 200 of FIG. 2, according to embodiments.

Referring to FIG. 12, in operation S701, the wireless communication device 200 may receive cell common signals and a PDSCH DMRS in a first slot. The cell common signals may include at least one of an SSB, a CSI-RS, or a TRS.

In operation S703, the wireless communication device 200 may detect RMS values for the received power of each of the cell common signals and the PDSCH DMRS in the first slot.

In operation S705, the wireless communication device 200 may set a target RMS value associated with a second slot subsequent to the first slot, based on the detected RMS values. The wireless communication device 200 may receive RS configuration information from the base station. The wireless communication device 200 may set the target RMS value associated with the second slot, further based on the configuration information.

According to embodiments, the wireless communication device 200 may determine the target RMS value, based on the largest value among the RMS values. The wireless communication device 200 may amplify the RMS values, based on the target RMS value. The amplified RMS values are not greater than a threshold value. For example, the entire range of the output signal of the VGA of the wireless communication device 200 may not exceed the dynamic range of the ADC. The threshold value may be set such that the output signal of the VGA does not exceed the dynamic range of the ADC.

According to embodiments, the target RMS value associated with the second slot may be a target RMS value applied to an entire second slot interval.

According to embodiments, the target RMS value associated with the second slot may include an RMS value for each of symbols of the second slot. The target RMS value for symbols in which the cell common signals and the PDSCH DMRS are received simultaneously (or contemporaneously) among the symbols of the second slot may be set based on the RMS value for the received power of the cell common signals and the RMS value for the received power of the PDSCH DMRS. The target RMS value for symbols in which the cell common signals are not received among the symbols of the second slot may be set based on the RMS value for the received power of the PDSCH DMRS (e.g., without the RMS value for the received power of the cell common signals).

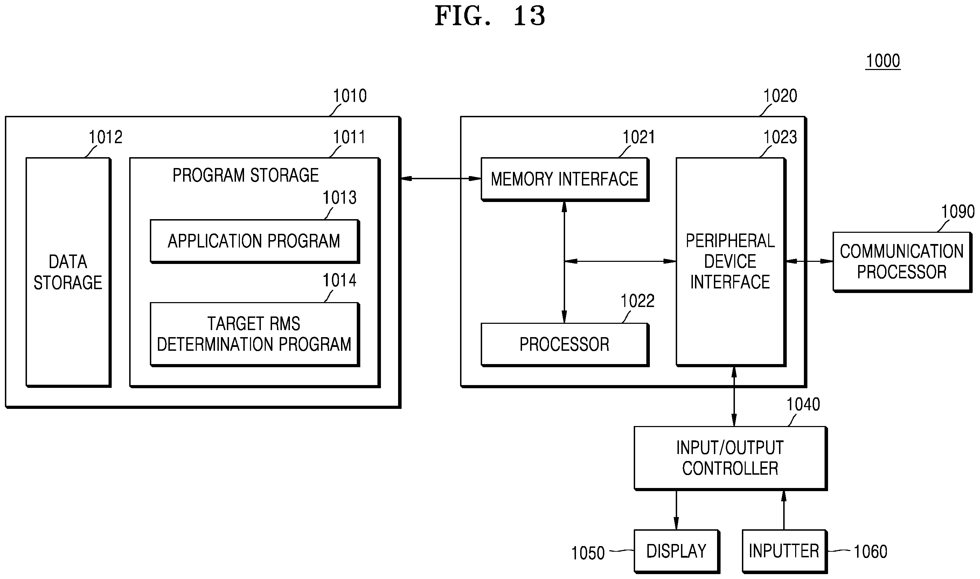

FIG. 13 illustrates a block diagram of an electronic device 1000 according to embodiments.

Referring to FIG. 13, the electronic device 1000 may include a memory 1010, a processor unit 1020, an input/output controller 1040, a display 1050, an inputter 1060, and/or a communication processor 1090. A plurality of memories 1010 may be provided. The respective elements are described below.

The memory 1010 may include a program storage 1011 that stores a program for controlling the operation of the electronic device 1000 and/or a data storage 1012 that stores data generated during the execution of the program. The data storage 1012 may store data necessary (or otherwise, used) for operations of an application program 1013 and/or a target RMS determination program 1014. The program storage 1011 may include the application program 1013 and/or the target RMS determination program 1014. The program included in the program storage 1011 is a set of instructions and may be referred to as an instruction set.

The application program 1013 may include an application program that operates on the electronic device 1000. That is, the application program 1013 may include instructions of an application driven by a processor 1022. The target RMS determination program 1014 may determine a target RMS value for a subsequent slot or symbol according to embodiments.

A peripheral device interface 1023 may control the connection between an input/output peripheral device of a base station, the processor 1022, and/or a memory interface 1021. The processor 1022 may control the base station to provide a relevant service by using at least one software program. In this case, the processor 1022 may execute at least one program stored in the memory 1010 to provide a service corresponding to the program.

The input/output controller 1040 may provide an interface between an input/output device, such as the display 1050 and/or the inputter 1060, and the peripheral device interface 1023. The display 1050 may display state information, input text, moving pictures, still pictures, etc. For example, the display 1050 may display information about application programs driven by the processor 1022.

The inputter 1060 may provide input data, which is generated by the selection of the electronic device 1000, to the processor unit 1020 through the input/output controller 1040. At this time, the inputter 1060 may include a keypad including at least one hardware button, a touchpad that senses touch information, or the like. For example, the inputter 1060 may provide touch information (e.g., touch, touch movement, and/or touch release, which are detected through the touch pad) to the processor 1022 through the input/output controller 1040. The electronic device 1000 may include the communication processor 1090 that performs a communication function for voice communication and data communication.

Conventional devices and methods for controlling an amplification gain of received signals set the amplification gain based on a strength of a UE-specific signal (e.g., a PDSCH DMRS). However, in scenarios in which the conventional devices receive the UE-specific signal and a cell common signal in the same slot (or a similar slot), and a degree of mismatch between the UE-specific signal and the cell common signal with respect to signal power is sufficiently high (e.g., due to the conventional devices being nearby a base station of the cell), the higher power cell common signal may be clipped based on the amplification gain being set based on the lower power UE-specific signal, thereby resulting in inter carrier interference (ICI). Accordingly, the conventional devices suffer from excessive ICI and insufficient communication reliability.

However, according to embodiments, improved devices and methods are provided for controlling an amplification gain of received signals. For example, the improved devices and methods may set the amplification gain taking into consideration a root mean square (RMS) value of signal strength for each of the UE-specific signal and the cell common signal (e.g., based on a larger among the RMS values), and such that the amplified gain does not exceed a threshold corresponding to a dynamic range of the ADC. Accordingly, even in scenarios in which the improved devices receive the UE-specific signal and a cell common signal in the same slot (or a similar slot), and a degree of mismatch between the UE-specific signal and the cell common signal with respect to signal power is sufficiently high (e.g., due to the improved devices being nearby a base station of the cell), clipping of the cell common signal is prevented or reduced. Therefore, the improved devices and methods overcome the deficiencies of the conventional devices and methods to at least reduce ICI and improve communication reliability.

According to embodiments, operations described herein as being performed by the wireless communication system 10, each of the wireless communication devices 120 and/or 130, the base station 110, the wireless communication device 200, the processor 201, the RFIC 202, the wireless communication device 200', the amplification circuit 300, the AGC 400, the wireless communication device 200", the VGA, the target RMS controller 404, the detector 401, the filter 402, the error amplifier 403, the wireless communication device 200''', the low-noise amplifier (LNA), the mixer MIX, the ADC, the modem, the RMS calculator 405, the comparison circuit 406, the electronic device 1000, the processor unit 1020, the input/output controller 1040, the communication processor 1090, the target RMS determination program 1014, the peripheral device interface 1023, the processor 1022 and/or the memory interface 1021 may be performed by processing circuitry. The term 'processing circuitry,' as used in the present disclosure, may refer to, for example, hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), a digital signal processor, a microcomputer, a field programmable gate array (FPGA), a System-on-Chip (SoC), a programmable logic unit, a microprocessor, application-specific integrated circuit (ASIC), etc.

The various operations of methods described above may be performed by any suitable device capable of performing the operations, such as the processing circuitry discussed above. For example, as discussed above, the operations of methods described above may be performed by various hardware and/or software implemented in some form of hardware (e.g., processor, ASIC, etc.).

The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or operations of a method or algorithm, and/or functions, described in connection with embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium (e.g., the memory 203, the memory 101, etc.). A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

Embodiments may be described with reference to acts and symbolic representations of operations (e.g., in the form of flow charts, flow diagrams, data flow diagrams, structure diagrams, block diagrams, etc.) that may be implemented in conjunction with units and/or devices discussed in more detail herein. Although discussed in a particular manner, a function or operation specified in a specific block may be performed differently from the flow specified in a flowchart, flow diagram, etc. For example, functions or operations illustrated as being performed serially in two consecutive blocks may actually be performed concurrently, simultaneously, contemporaneously, or in some cases be performed in reverse order. It is also noted that functions or operations specified in the blocks may be performed in parallel fashion and/or an iterative fashion.

Although terms of "first" or "second" may be used to explain various components, the components are not limited to the terms. These terms should be used only to distinguish one component from another component. For example, a "first" component may be referred to as a "second" component, or similarly, and the "second" component may be referred to as the "first" component. Expressions such as "at least one of" when preceding a list of elements, modify the entire list of elements and do not modify the individual elements of the list. For example, the expression, "at least one of a, b, and c," should be understood as including only a, only b, only c, both a and b, both a and c, both b and c, all of a, b, and c, or any variations of the aforementioned examples. As used herein the term "and/or" includes any and all combinations of one or more of the associated listed items.

According to embodiments, any of the arrows or lines that interconnect illustrated components in the drawings may represent physical data paths, logical data paths, or both. A physical data path may comprise a databus or a transmission line, for example. A logical data path may represent a communication or data message between software programs, software modules, Subroutines, or other software constituents or components.

While the inventive concepts have been particularly shown and described with reference to embodiments thereof, it will be understood that various changes in form and details may be made therein without departing from the scope of the following claims.

**Claims**

1. An operating method of a wireless communication device, the operating method comprising:

   detecting a first root mean square (RMS) value for a received power of a first signal in an $n^{th}$ slot, n being a positive integer, and the first signal being a synchronization signal block (SSB), a channel state information-reference signal (CSI-RS) or a tracking reference signal (TRS);
   detecting a second RMS value for a received power of a second signal in the $n^{th}$ slot, the second signal being a physical downlink shared channel (PDSCH) demodulation reference signal (DMRS);
   determining a target RMS value for an $(n+1)^{th}$ slot based on at least one of the first RMS value or the second RMS value; and
   controlling a gain for the first signal and a gain for the second signal based on the target RMS value for the $(n+1)^{th}$ slot.

2. The operating method of claim 1, wherein the determining of the target RMS value for the $(n+1)^{th}$ slot comprises determining the target RMS value for the $(n+1)^{th}$ slot based on a larger value between the first RMS value and the second RMS value; and
   wherein the controlling the gain for the first signal and the gain for the second signal comprises controlling the gain for the first signal and the gain for the second signal so that both are not greater than a threshold value.

3. The operating method of claim 1 or claim 2, further comprising:

   storing a first accumulated RMS value for the received power of the first signal, the first accumulated RMS value being accumulated up to an $(n-1)^{th}$ slot;
   storing a second accumulated RMS value for the received power of the first signal, the second accumulated RMS value being accumulated up to the $n^{th}$ slot based on the first RMS value and the first accumulated RMS value;
   storing a third accumulated RMS value for the received power of the second signal, the third accumulated RMS value being accumulated up to the $(n-1)^{th}$ slot; and
   storing a fourth accumulated RMS value for the received power of the second signal, the fourth accumulated RMS value being accumulated up to the $n^{th}$ slot based on the second RMS value and the third accumulated RMS value.

4. The operating method of claim 3, wherein:

   the second accumulated RMS value is accumulated based on a relationship of the second accumulated RMS value = $\alpha$(the first RMS value)+(1-$\alpha$)(the first accumulated RMS value), $\alpha$ being a real number from 0 to 1; and
   the fourth accumulated RMS value is accumulated based on a relationship of the fourth accumulated RMS value = $\beta$(the second RMS value)+(1-$\beta$)(the third accumulated RMS value), $\beta$ being a real number from 0 to 1.

5. The operating method of claim 4, further comprising:
   decreasing the $\alpha$ and the $\beta$ based on an increase in a Doppler spread of a channel on which the first signal and the second signal are received.

**6.** The operating method of claim 4 or claim 5, further comprising:

reducing the $\alpha$ in response to a difference between the first RMS value and the first accumulated RMS value being greater than a specific value; or
maintaining the $\alpha$ in response to the difference between the first RMS value and the first accumulated RMS value being less than or equal to the specific value.

**7.** The operating method of any of claims 4 to claim 6, further comprising:

reducing the $\beta$ in response to a difference between the second RMS value and the third accumulated RMS value being greater than a specific value; or
maintaining the $\beta$ in response to the difference between the second RMS value and the third accumulated RMS value being less than or equal to the specific value.

**8.** The operating method of any of claims 3 to 7, wherein the determining of the target RMS value for the $(n+1)^{th}$ slot comprises determining the target RMS value for the $(n+1)^{th}$ slot based on a target RMS value for the $n^{th}$ slot, the second accumulated RMS value and the fourth accumulated RMS value.

**9.** The operating method of any preceding claim, further comprising:

receiving configuration information for the first signal from a base station,
wherein the determining of the target RMS value for the $(n+1)^{th}$ slot includes determining the target RMS value for the $(n+1)^{th}$ slot in symbol units of the $(n+1)^{th}$ slot based on the configuration information.

**10.** The operating method of claim 9, wherein:

the $(n+1)^{th}$ slot comprises a first symbol group and a second symbol group, the first signal and the second signal received simultaneously in the first symbol group, and only the second signal being received in the second symbol group; and
the determining of the target RMS value for the $(n+1)^{th}$ slot includes determining the target RMS value for the $(n+1)^{th}$ slot symbol units based on the second symbol group being greater than or equal to a specific ratio.

**11.** The operating method of any preceding claim, wherein

the $(n+1)^{th}$ slot comprises a first symbol and a second symbol, the first signal and the second signal being received simultaneously in the first symbol, and only the second signal being received in the second symbol; and
the determining of the target RMS value for the $(n+1)^{th}$ slot comprises:

determining a first sub-target RMS value for the first symbol based on the first RMS value and the second RMS value, and
determining a second sub-target RMS value for the second symbol based on the second RMS value.

**12.** A wireless communication device comprising:

processing circuitry configured to:

detect a first root mean square (RMS) value for a received power of a first signal in an $n^{th}$ slot, n being a positive integer, and the first signal being a synchronization signal block (SSB), a channel state information-reference signal (CSI-RS) or a tracking reference signal (TRS),
detect a second RMS value for a received power of a second signal in the $n^{th}$ slot, the second signal being a physical downlink shared channel (PDSCH) demodulation reference signal (DMRS),
determine a target RMS value for an $(n+1)^{th}$ slot based on at least one of the first RMS value or the second RMS value,
amplify a gain for the first signal and a gain for the second signal based on the target RMS value for the $(n+1)^{th}$ slot.

**13.** The wireless communication device of claim 12, wherein

the processing circuitry is configured to determine the target RMS value for the $(n+1)^{th}$ slot based on a larger value between the first RMS value and the second RMS value, and
the processing circuitry is configured to set the gain for the first signal and the gain for the second signal to be not greater than a threshold value.

**14.** The wireless communication device of claim 12 or claim 13, further comprising:

a memory,
wherein the processing circuitry is configured to store in the memory

a first accumulated RMS value for the received power of the first signal, the first accumulated RMS value being accumulated up to an $(n-1)^{th}$ slot,
a second accumulated RMS value for the received power of the first signal, the second accumulated RMS value being accumulated up to the $n^{th}$ slot based on the first RMS value and the first accumulated RMS value,
a third accumulated RMS value for the received power of the second signal, the third accumulated RMS value being accumulated up to the $(n-1)^{th}$ slot,
a fourth accumulated RMS value for the received power of the second signal, the fourth accumulated RMS value being accumulated up to the $n^{th}$ slot based on the second RMS value and the third accumulated RMS value.

**15.** The wireless communication device of claim 14, wherein

the second accumulated RMS value is accumulated based on a relationship of the second accumulated RMS value = $\alpha$(the first RMS value)+$(1-\alpha)$(the first accumulated RMS value), $\alpha$ being a real number from 0 to 1; and
the fourth accumulated RMS value is accumulated based on a relationship of the fourth accumulated RMS value = $\beta$(the second RMS value)+$(1-\beta)$(the third accumulated RMS value), $\beta$ being a real number from 0 to 1.

# FIG. 1

FIG. 2

ANTENNAS

200

201
PROCESSOR(s)

202
RFIC

203
MEMORY

# FIG. 3

200'

RECEIVED SIGNAL → AMPLIFICATION CIRCUIT 300 → AS → AGC 400

GC

# FIG. 4

EP 4 675 945 A1

FIG. 5

# FIG. 6A

| DISTINGUISH AND STORE POWER LEVELS OF SIGNALS, INCLUDING SSB, CSI–RS, TRS, AND PDSCH DMRS, FOR EACH TYPE OF SIGNALS | S101 |

↓

| SET TARGET RMS VALUE BASED ON POWER LEVEL OF EACH OF SIGNALS | S103 |

EP 4 675 945 A1

# FIG. 6B

SLOT    0   1   2   3     $\cdots$     n   n+1     $\cdots$     k   k+1

TRS

BUFFER UPDATE

TRS POWER BUFFER

# FIG. 6C

# FIG. 7A

DISTINGUISH AND STORE POWER LEVELS OF SIGNALS, INCLUDING SSB, CSI-RS, TRS, AND PDSCH DMRS, FOR EACH TYPE OF SIGNALS — S201

ACCUMULATE POWER LEVELS — S203

SET TARGET RMS VALUE BASED ON ACCUMULATED POWER LEVEL OF EACH OF SIGNALS — S205

# FIG. 7B

EP 4 675 945 A1

# FIG. 8A

DISTINGUISH AND STORE POWER LEVELS
OF SIGNALS, INCLUDING SSB, CSI−RS,
TRS, AND PDSCH DMRS, FOR EACH TYPE
OF SIGNALS — S301

ACCUMULATE POWER LEVEL THROUGH
IIR FILTERING — S303

IS DIFFERENCE
BETWEEN ACCUMULATED
POWER LEVEL AND POWER LEVEL OF
CURRENT SLOT GREATER THAN
PRESET VALUE ? — S305

No          Yes

MAINTAIN IIR FILTER
COEFFICIENTS — S307

REDUCE IIR COEFFICIENT
VALUE FOR CURRENT SLOT — S309

# FIG. 8B

TRS PERIOD = 20slots

SLOT

$n$  $n+1$    $n+20$ $n+21$      $n+40$ $n+41$          $n+60$ $n+61$

TRS

IRREGULAR FLAG
= True

$\Delta P > X$

TRS POWER LEVEL

EP 4 675 945 A1

# FIG. 9A

RECEIVE RS CONFIGURATION INFORMATION FROM BASE STATION — S401a

DETERMINE, BASED ON RS CONFIGURATION INFORMATION, WHETHER TO UPDATE TARGET RMS VALUE BASED ON ANY ONE OF SYMBOL AND SLOT — S403a

# FIG. 9B

# FIG. 10

DISTINGUISH POWER LEVELS OF SIGNALS, INCLUDING SSB, CSI-RS, TRS, AND PDSCH DMRS, INTO CELL COMMON SIGNAL GROUP AND UE-SPECIFIC SIGNAL GROUP AND THEN STORE POWER LEVELS OF SIGNALS  — S501

SET TARGET RMS VALUE, BASED ON POWER LEVELS OF CELL COMMON SIGNAL GROUP AND UE-SPECIFIC SIGNAL GROUP  — S503

# FIG. 11

DETECT FIRST RMS VALUE FOR RECEIVED
POWER OF FIRST SIGNAL IN $n^{TH}$ SLOT
(WHERE N IS POSITIVE INTEGER) — S601

DETECT SECOND RMS VALUE FOR RECEIVED
POWER OF SECOND SIGNAL IN $n^{TH}$ SLOT — S603

DETERMINE TARGET RMS VALUE FOR $(n+1)^{TH}$ SLOT,
BASED ON AT LEAST ONE OF FIRST RMS VALUE
OR SECOND RMS VALUE — S605

CONTROL GAIN FOR FIRST SIGNAL AND GAIN FOR
SECOND SIGNAL, BASED ON TARGET RMS VALUE — S607

# FIG. 12

```
┌─────────────────────────────────────────┐
│  RECEIVE CELL COMMON SIGNALS AND PDSCH   │── S701
│         DMRS IN FIRST SLOT               │
└─────────────────────────────────────────┘
                    │
                    ▼
┌─────────────────────────────────────────┐
│  DETECT RMS VALUES FOR RECEIVED POWER OF │
│  EACH OF CELL COMMON SIGNALS AND PDSCH   │── S703
│            DMRS IN FIRST SLOT            │
└─────────────────────────────────────────┘
                    │
                    ▼
┌─────────────────────────────────────────┐
│    SET TARGET RMS VALUE ASSOCIATED WITH  │
│   SECOND SLOT SUBSEQUENT TO FIRST SLOT,  │── S705
│     BASED ON DETECTED RMS VALUES         │
└─────────────────────────────────────────┘
```

# FIG. 13

1000

1010

1012                                    1011

PROGRAM STORAGE

1013

DATA
STORAGE        APPLICATION PROGRAM

1014

TARGET RMS
DETERMINATION PROGRAM

1020

1021        1023

MEMORY INTERFACE

PERIPHERAL
DEVICE
INTERFACE

1090

COMMUNICATION
PROCESSOR

1022

PROCESSOR

1040

INPUT/OUTPUT
CONTROLLER

1050 — DISPLAY      INPUTTER — 1060

EP 4 675 945 A1

Europäisches
Patentamt

European
Patent Office

Office européen
des brevets

# EUROPEAN SEARCH REPORT

**Application Number**

EP 25 16 4505

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | QUALCOMM INCORPORATED: "On HST UE Demod Test", 3GPP DRAFT; R4-1906951 HST UE DEMOD TEST_V1, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG4, no. Reno, USA; 20190513 - 20190517 13 May 2019 (2019-05-13), XP051733805, Retrieved from the Internet: URL:http://www.3gpp.org/ftp/Meetings%5F3GP P%5FSYNC/RAN4/Docs/R4%2D1906951%2Ezip [retrieved on 2019-05-13] * the whole document * ----- | 1-15 | INV. H04B17/318 H03G3/20 |
| A | HYUNWOO CHO ET AL: "Discussion on RRM requirements of SSBless Scell for inter-band CA", 3GPP DRAFT; R4-2309428; TYPE DISCUSSION; NETW_ENERGY_NR-CORE, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE , vol. RAN WG4, no. Incheon, KR; 20230522 - 20230526 15 May 2023 (2023-05-15), XP052318153, Retrieved from the Internet: URL:https://www.3gpp.org/ftp/TSG_RAN/WG4_R adio/TSGR4_107/Docs/R4-2309428.zip R4-2309428 Discussion on RRM requirements of SSBless Scell for inter-band CA.docx [retrieved on 2023-05-15] * the whole document * ----- | 1-15 | TECHNICAL FIELDS SEARCHED (IPC) H04B H03G |

-/--

The present search report has been drawn up for all claims

| Place of search | Date of completion of the search | Examiner |
|---|---|---|
| The Hague | 1 September 2025 | Boetzel, Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................
& : member of the same patent family, corresponding document

EPO FORM 1503 03.82 (P04C01)

page 1 of 2

Europäisches
Patentamt

European
Patent Office

Office européen
des brevets

## EUROPEAN SEARCH REPORT

**Application Number**

EP 25 16 4505

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2004/004933 A1 (ZHU JUNJIE [SG] ET AL) 8 January 2004 (2004-01-08) * the whole document * ----- | 1-15 | |
| A | INTEL CORPORATION: "Remaining issues on reference signal and QCL", 3GPP DRAFT; R1-1810752 REMAINING ISSUES ON REFERENCE SIGNAL AND QCL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FR , vol. RAN WG1, no. Chengdu, China; 20181008 - 20181012 29 September 2018 (2018-09-29), XP051518156, Retrieved from the Internet: URL:http://www.3gpp.org/ftp/tsg%5Fran/WG1%5FRL1/TSGR1%5F94b/Docs/R1%2D1810752%2Ezip [retrieved on 2018-09-29] * the whole document * ----- | 1-15 | |
| A | US 7 994 840 B2 (MAXIM INTEGRATED PRODUCTS [US]) 9 August 2011 (2011-08-09) * the whole document * ----- | 1-15 | |

TECHNICAL FIELDS
SEARCHED (IPC)

The present search report has been drawn up for all claims

| Place of search | Date of completion of the search | Examiner |
|---|---|---|
| The Hague | 1 September 2025 | Boetzel, Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

**EP 4 675 945 A1**

## ANNEX TO THE EUROPEAN SEARCH REPORT
## ON EUROPEAN PATENT APPLICATION NO.

EP 25 16 4505

01-09-2025

| Patent document cited in search report | Publication date | Patent family member(s) | | Publication date |
|---|---|---|---|---|
| US 2004004933 A1 | 08-01-2004 | SG | 129229 A1 | 26-02-2007 |
| | | US | 2004004933 A1 | 08-01-2004 |
| US 7994840 B2 | 09-08-2011 | CN | 102037367 A | 27-04-2011 |
| | | CN | 103326683 A | 25-09-2013 |
| | | DE | 112009001238 T5 | 05-05-2011 |
| | | US | 2009284300 A1 | 19-11-2009 |
| | | US | 2011285458 A1 | 24-11-2011 |
| | | WO | 2009142903 A2 | 26-11-2009 |

EPO FORM P0459